# EUROPÄISCHE PATENTSCHRIFT

(11) **EP 1 887 650 B1**
(45) Veröffentlichungstag und Bekanntmachung des Hinweises auf die Patenterteilung: **14.04.2010**
(21) Anmeldenummer: 07112155.2
(22) Anmeldetag: 10.07.2007
(51) Int. Cl.: H01Q 1/24, H04Q 9/04, H04M 1/02

(54) **Mobiles Kommunikationsgerät mit integrierter Schlitzantenne**
Mobile communications device with integrated slot antenna
Appareil de communication mobile doté d'une antenne fendue intégrée

(30) Priorität: 09.08.2006 DE 102006037244
(43) Veröffentlichungstag der Anmeldung: 13.02.2008
(73) Patentinhaber: Siemens Aktiengesellschaft Österreich, 1210 Wien (AT)
(72) Erfinder: Hellinger, Leopold, 3710, Ziersdorf (AT); Neumann, Gerhard, 3231, St. Margarethen (AT); Peinsipp, Paul, 2460, Bruck/I (AT)

(56) Entgegenhaltungen:
- EP-A- 1 677 387
- WO-A-2005/031914
- US-A1- 2003 179 144
- US-A1- 2005 017 909

## Beschreibung

### Technisches Gebiet

Die Erfindung betrifft ein mobiles Kommunikationsgerät mit einem Funkmodul, an welches eine Antennenstruktur angeschlossen ist, und mit einer Funkmodul-Befestigungsvorrichtung, um das Funkmodul auf einem plattenförmigen Schaltungsträger zu befestigen.

### Stand der Technik

Mobile Kommunikationsgeräte, wie beispielsweise Mobilfunkgeräte, Smartphones, PDAs oder sog. "on-board-units" in Kraftfahrzeugen, verwenden zur leitungsungebundenen Signalübertragung ein sog. Funkmodul, das über eine Antennenanschlussleitung mit einer im Gehäuse des Kommunikationsgerätes integrierten Antenne elektrisch verbunden ist. Die Antennenanschlussleitung besteht aus einem Koaxialkabel, das mittels eines Koaxial-Steckverbinders an das Funkmodul angesteckt ist. Ein solches Funkmodul ist beispielsweise das Siemens-Funkmodul MC55/56, das äußerst kompakte Abmessungen und ein sehr geringes Gewicht aufweist. Es wird vor allem für die Massenproduktion von Anwendungen im Consumer-Bereich mobiler Kommunikationsendgeräte eingesetzt (www.siemens.com/wm). Verschiedene Varianten dieses Tri-Band-Moduls MC55/56 decken sämtliche GSM/GPRS-Netze weltweit ab und gewährleisten eine größtmögliche Flexibilität bei der Integration von Sprach- und Datenkommunikation. Zur Befestigung des Funkmoduls MC55/56 auf einer Leiterplatte dient häufig ein Formteil aus Kunststoff, das auf der Leiterplatte befestigt ist.

Der Antennenanschluss beansprucht im Kommunikationsgerät nicht nur ein vergleichsweise großes Bauvolumen, sondern stellt auch einen erheblichen Kostenanteil dar. Man ist aber bestrebt, mobile Kommunikationsendgeräte mit möglichst geringen Herstellungskosten zu fertigen und in den Abmessungen so klein und kompakt wie möglich auszuführen.

### Darstellung der Erfindung

Es ist eine Aufgabe der vorliegenden Erfindung ein mobiles Kommunikationsgerät anzugeben, das kostengünstig herstellbar ist und das ein möglichst kleines Bauvolumen und ein geringes Gewicht aufweist.

Diese Aufgabe wird durch die Merkmale des Patentanspruchs 1 gelöst. Vorteilhafte Ausgestaltungen sind Gegenstand von abhängigen Ansprüchen.

Ein Hauptaspekt der erfindungsgemäß vorgeschlagenen Lösung besteht darin, dass die Antennenstruktur und die Funkmodul-Befestigungsvorrichtung eine bauliche Einheit bilden und dass der Antennenanschluss durch Federkontakte hergestellt ist, die in einem Anschlussbereich der Antennenstruktur ausgebildet sind. Dadurch entfällt ein teurer Koaxial-Antennenanschluss. Der Platzbedarf für den Antennenanschluss ist vergleichsweise gering. Bei der Montage erfolgt der elektrische Anschluss der Antenne an das Funkmodul gleichzeitig mit der Befestigung des Funkmoduls auf dem Schaltungsträger. Dies vereinfacht die Montage erheblich. Es können verstärkt automatische Handhabungssysteme eingesetzt werden, sodass die Herstellung des elektrischen Gerätes insgesamt mit geringeren Kosten möglich ist.

Hinsichtlich geringer Herstellungskosten kann es besonders günstig sein, wenn die Federkontakte und die Antennenstruktur aus einem Stück hergestellt sind, beispielsweise aus einer Metallplatte oder einem Blech.

Eine bevorzugte Ausführungsform kann dadurch gekennzeichnet sein, dass die Antennenstruktur als eine planare Schlitzantenne ausgebildet ist, dass in einem Anschlussbereich der Schlitzantenne zwei zungenförmige Fortsetzungen ausgebildet sind und dass die Federkontakte aus diesen zungenförmigen Fortsetzungen geformt sind.

In einer bevorzugten Ausführungsform kann vorgesehen sein, dass die Funkmodul-Befestigungsvorrichtung als Kunststoff-Halbschale ausgebildet ist, dass die Antennenstruktur an einer, vom Träger abgewandten Außenseite der Kunststoffhalbschale angeordnet ist und die Federkontakte durch eine, im zusammengebauten Zustand mit den Kontaktflächen des Funkmoduls korrespondierenden, in der Kunststoffhalbschale vorgesehenen Ausnehmung hindurch greifen. Die Kunststoff-Halbschale kann kostengünstig in Spritzgusstechnik hergestellt werden. Durch die Befestigung der Antennenstruktur an der Außenseite dieses Kunststoffteils, ist die Antenne vom Funkmodul beabstandet; anderseits bildet die Antenne zusammen mit der Funkmodul-Befestigungsvorrichtung eine bauliche Einheit, was die Handhabung bei der Fertigung erleichtert.

Unter fertigungstechnischen Gesichtspunkten kann es günstig sein, wenn in einem zusammengebauten Zustand jeder Federkontakt jeweils durch eine zum Funkmodul weisende Abkröpfung der zungenförmigen Fortsetzung gebildet ist.

Um einen möglichst geringen Übergangswiderstand zwischen Federkontakt und Kontaktfläche zu erreichen kann es günstig sein, wenn zumindest die zum Funkmodul weisende Abkröpfung der zungenförmigen Fortsetzung mit einer korrosionsbeständigen Beschichtung beschichtet ist. Eine solche Beschichtung kann beispielsweise durch ein Edelmetall oder eine Edelmetalllegierung erfolgen.

Die mechanische Verbindung zwischen Antennenstruktur und Funkmodul-Befestigungsvorrichtung lässt sich mit vergleichsweise geringem Aufwand durch Formschluss, beispielsweise als Nietverbindung herstellen.

Mit geringem Aufwand kann die Schlitzantenne samt Federkontakte als Blech-Biege-Stanzteil gefertigt werden.

### Kurzbeschreibung der Zeichnung

Zur weiteren Erläuterung der Erfindung wird im nachfolgenden Teil der Beschreibung auf die Zeichnungen Bezug genommen, in denen weitere vorteilhafte Ausgestaltungen, Einzelheiten und Weiterbildungen der Erfindung zu entnehmen sind. Es zeigen:
- Figur 1: eine Funkmodul-Befestigungsvorrichtung mit integrierter Antenne;
- Figur 2: eine Funkmodul-Befestigungsvorrichtung mit integrierter Antenne vor der Montage auf einem plattenförmigen Träger;
- Figur 3: eine Funkmodul-Befestigungsvorrichtung, mittels derer ein Funkmodul auf dem plattenförmigen Träger fixiert ist.

### Ausführung der Erfindung

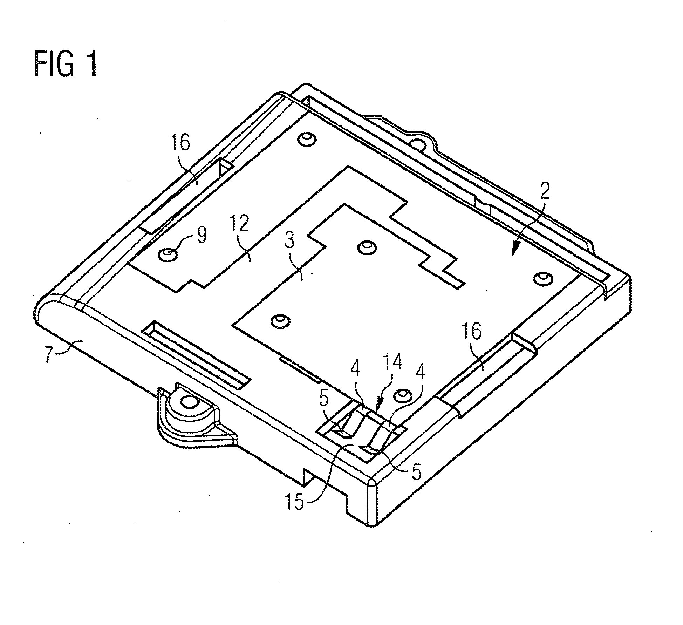

Die Figur 1 zeigt eine Funkmodul-Befestigungsvorrichtung 7 die gleichzeitig als Träger für eine GSM-Antenne 2 dient. Die Funkmodul-Befestigungsvorrichtung 7 ist im vorliegenden Ausführungsbeispiel als Halbschale aus Kunststoff hergestellt. Die Antenne 2 besteht im Wesentlichen aus einer elektrisch leitenden Antennenstruktur 3, das ist der eigentliche Strahler, der zur sendeseitigen Abgabe bzw. empfangsseitigen Aufnahme elektromagnetischer Wellen dient. Die Antennenstruktur 3 ist im vorliegenden Beispiel durch eine flächige metallische Struktur (einer dünnen Metallplatte) gebildet. Für die Abstrahlung und den Empfang der elektromagnetischen Wellen sorgen Unterbrechungen in dieser Metallplatte. Die Unterbrechungen sind als Schlitze gezeichnet, deren Schlitzgeometrie mit dem Bezugszeichen 12 gekennzeichnet ist. Die Schlitzgeometrie 12 ist auf die verwendete Trägerfrequenz bzw. Trägerfrequenzen der Funkübertragung abgestimmt. Mit dem Bezugszeichen 14 ist ein Antennenanschlussbereich gekennzeichnet. In diesem Antennenanschlussbereich 14 ist die planare Antennenstruktur 3 durch zwei Streifenleiter zungenförmig fortgesetzt. Diese Streifenleiter verlaufen im wesentlichen parallel zueinander und bilden eine vergleichsweise kurze Antennenanschlussleitung 4. Sie sind endseitig jeweils gekröpft. Durch die Abkröpfung werden Federkontakte 5 ausgebildet, die durch eine Ausnehmung 15 in der Kunststoff-Halbschale 7 hindurch greifen, und - wie im Folgenden noch näher erläutert wird -, jeweils eine auf einem Funkmodul 1 vorhandene Kontaktfläche 6 kontaktieren. Die Funkmodul-Befestigungsvorrichtung 7 und die Antenne 2 bilden eine bauliche Einheit, das heißt die Antennenstruktur 3 ist mit der Kunststoff-Halbschale 7 unlösbar verbunden. In den Zeichnungen der Figuren 1 bis 3 ist diese unlösbare Verbindung durch sechs Nietverbindung 9 dargestellt. Selbstverständlich kann diese Verbindung auch anders ausgeführt sein, beispielsweise durch eine andere formschlüssige Verbindung oder durch eine stoffschlüssige Verbindung, z.B. durch eine Klebeverbindung. Die Kunststoff-Halbschale 7 weist neben der Ausnehmung 15 weitere Ausnehmungen 16 auf, welche die Wärmeabfuhr aus dem Funkmodul 1 begünstigen, aber für die vorliegende Erfindung ohne Bedeutung sind.

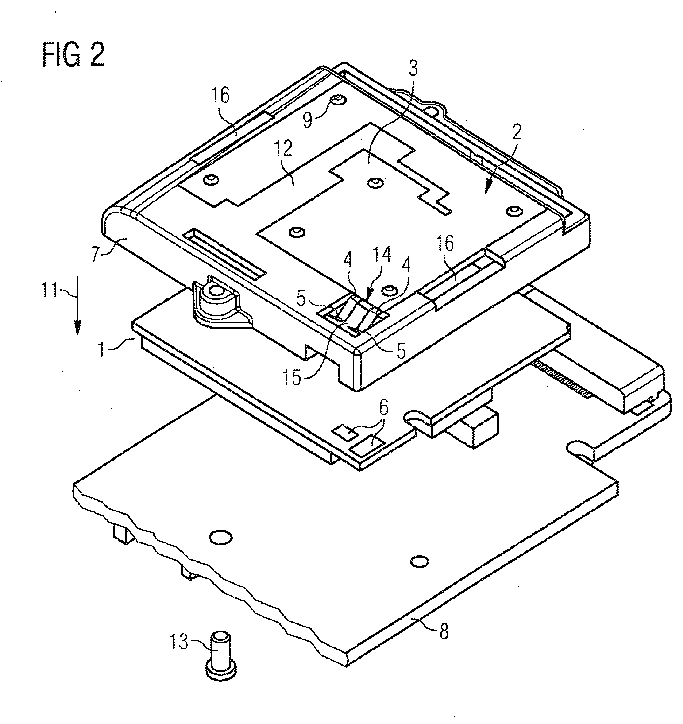

In der auseinander gezogenen Darstellung der Figur 2 ist in einem Ausschnitt ein Teil des mobilen Kommunikationsgerätes dargestellt. Die Figur 2 zeigt als Ausriss den plattenförmigen Schaltungsträger 8 des Kommunikationsgerätes. Die Darstellung entspricht einem Zustand vor der Montage des Funkmoduls 1. Das Funkmodul 1 liegt zwischen der schalenförmigen Funkmodul-Befestigungsvorrichtung 7 und dem plattenförmigen Träger 8. Im dargestellten Ausführungsbeispiel ist das Funkmodul 1 das eingangs erwähnte Wireless Modul MC55/56 der Firma Siemens. Die Abmessungen dieses miniaturisierten Funkmoduls betragen 35 * 32,5 * 2,95 Millimeter und bei einer Masse von 5,5 g.

Wie in der Explosionsdarstellung der Figur 2 gezeigt, wird während der Montage die Funkmodul-Befestigungsvorrichtung 7 in Richtung des Pfeils 11 auf den plattenförmigen Träger 8 abgesenkt. Dabei kontaktieren die Federkontakte 5, die durch die Ausnehmung 15 hindurch ragen, korrespondierende Kontaktflächen 6, die auf einer Oberseite des Funkmoduls 1 ausgebildet sind.

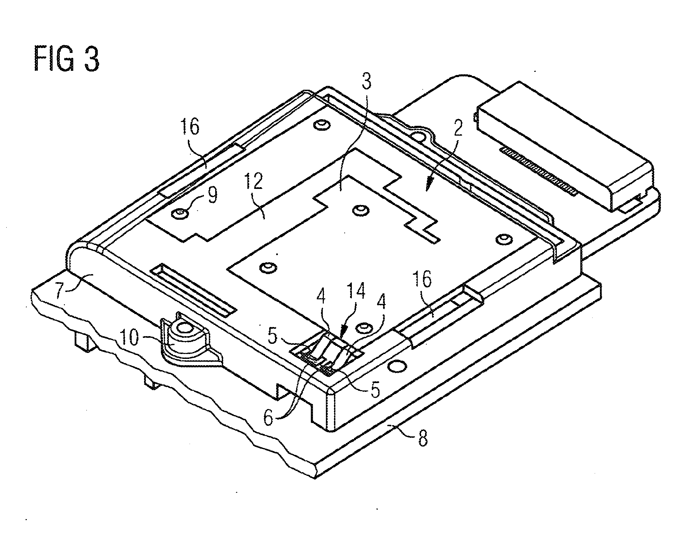

Die Figur 3 zeigt den Zustand nach der Montage. Die beiden Federkontakte 5 liegen nun unter elastischer Vorspannung auf den jeweils zugeordneten Kontaktflächen 6 des Funkmoduls 1 auf. Die Antenne 3 ist an das Funkmodul 1 elektrisch angeschlossen. Durch die aufgebrachte Federkraft ist sichergestellt, dass diese elektrische Verbindung auch bei Erschütterungen des mobilen Kommunikationsgerätes aufrechterhalten bleibt. Eine Beschichtung aus einer Goldlegierung stellt sicher, dass ein geringer Übergangswiderstand über eine lange Gebrauchsdauer aufrechterhalten bleibt. Die mechanische Verbindung zwischen der Funkmodul-Befestigungsvorrichtung 7 und dem Träger 9 ist durch eine Rastverbindung 10 hergestellt. Im vorliegenden Ausführungsbeispiel weist diese Rastverbindung ein Raststück 13 (Figur 2) auf, das von einer Unterseite des Trägers in eine entsprechende Bohrung des Trägers durchgesteckt und in eine korrespondierende Bohrung des Teils 7 einschnappt. Damit wird in einem Montageschritt zum einen der elektrische Anschluss der Antenne 2 an das Funkmodul 1 hergestellt und zum anderen das Funkmodul 1 auf dem Träger 8 mechanisch fixiert. In dieser Montagestellung ist das auf dem Träger 8 befestigte Funkmodul 1 mit nicht näher dargestellten Schaltungen des Kommunikationsgerätes elektrisch verbunden.

Durch die Erfindung entfällt also eine aufwändige und Platzbeanspruchende Verkabelung zwischen der Antenne 2 und dem Funkmodul 1. Folglich fällt der bislang erforderliche Einbauraum für das Koaxialkabel und für den Koaxial-Steckverbinder weg. Das erfindungsgemäße mobile Kommunikationsgerät baut kleiner auf und hat ein geringeres Gewicht.

Die Herstellung der Antennenstruktur 3 in Form einer Schlitzantenne kann als Blech-Biege-Stanzteil mittels eines Folge-Verbund-Werkzeuges in Großserie mit vergleichsweise geringen Herstellungskosten erfolgen.

Insgesamt verringern sich die Montagekosten bei der Herstellung des mobilen Kommunikationsgerätes, da für den Anschluss der Antenne 2 das Koaxial-Kabel weg fällt. In einem Arbeitsvorgang erfolgt sowohl die Montage des Befestigungsmoduls 1 auf dem Träger 8 als auch die elektrische Kontaktierung zwischen Antenne 2 und Funktionsmodul 1. Die Handhabung der filigranen Blech-Schlitzantenne 3 ist einfacher möglich, da die Funkmodul-Befestigungsvorrichtung 7 gleichzeitig als stabiler Träger für die Antenne 2 fungiert. Durch diese Vormontage bilden die Antennenstruktur 3 und die Funkmodul-Befestigungsvorrichtung 7 vorteilhaft eine bauliche Einheit, welche auch den Grad der Automatisierung begünstigt. Es können in verstärktem Ausmaß automatische Handhabungswerkzeuge eingesetzt werden, was insbesondere bei einer Fertigung in großen Stückzahlen von großem Vorteil ist.

Selbstverständlich kann das Befestigungsmittel 10 zwischen der Funkmodul-Befestigungsvorrichtung 7 und dem plattenförmigen Schaltungsträger 8 des Kommunikationsgerätes auch anderes ausgeführt sein, beispielsweise durch eine unlösbare Niet- oder Schnappverbindung oder - wenn das mobile Kommunikationsgerät als so genannte "on-board-unit" in einem KfZ eingesetzt wird, zusätzlich durch eine Schraubverbindung befestigt sein.

Zusammenstellung der verwendeten Bezugszeichen
- 1: Funkmodul
- 2: Antenne
- 3: Antennenstruktur, Schlitzantenne
- 4: Antennen-Anschlussleitung, Zungenförmige Fortsetzung von 3
- 5: Federkontakt
- 6: Kontaktfläche auf 1
- 7: Funkmodul-Befestigungsvorrichtung
- 8: Schaltungsträger
- 9: Befestigungsmittel zwischen 3 und 7, Nietverbindung
- 10: Befestigungsmittel zwischen 7 und 8, Rastverbindung
- 11: Pfeil
- 12: Schlitzgeometrie in 3
- 13: Raststück
- 14: Anschlussbereichen der Antennenstruktur 3
- 15: Ausnehmung in 7 für Federkontaktierung
- 16: Ausnehmung in 7

## Patentansprüche

1. Mobiles Kommunikationsgerät, umfassend:
- ein Funkmodul (1),
- eine an das Funkmodul (1) angeschlossene Antennenstruktur (3),
- eine Funkmodul-Befestigungsvorrichtung (7), um das Funkmodul (1) auf einem plattenförmigen Schaltungsträger (8) zu befestigen, **dadurch gekennzeichnet,**
- **dass** die Antennenstruktur (3) durch Befestigungsmittel (9) mit der Funkmodul-Befestigungsvorrichtung (7) verbunden ist, und
- **dass** in einem Anschlussbereich (14) der Antennenstruktur (3) Federkontakte (5) ausgebildet sind, welche in einem Zustand, in welchem das Funkmodul (1) auf dem Schaltungsträger (8) befestigt ist, eine elektrische Verbindung mit Kontaktflächen (6), die am Funkmodul (1) ausgebildet sind, herstellen.

2. Mobiles Kommunikationsgerät nach Anspruch 1, **dadurch gekennzeichnet, dass** die Federkontakte (5) einstückig mit der Antennenstruktur (3) ausgebildet sind.

3. Mobiles Kommunikationsgerät nach Anspruch 1 oder 2, **dadurch gekennzeichnet, dass** die Antennenstruktur (3) als eine planare Schlitzantenne ausgebildet ist, dass im Anschlussbereich (14) der Schlitzantenne zwei zungenförmige Fortsetzungen (4) ausgebildet sind und dass die Federkontakte (5) aus diesen zungenförmigen Fortsetzungen (4) geformt sind.

4. Mobiles Kommunikationsgerät nach Anspruch 3, **dadurch gekennzeichnet, dass** die Funkmodul-Befestigungsvorrichtung (7) als Kunststoff-Halbschale ausgebildet ist, dass die Antennenstruktur (3) an einer, vom Schaltungsträger (8) abgewandten Außenseite der Kunststoff-Halbschale angeordnet ist und die Federkontakte (5) durch eine Ausnehmung (15) hindurch greifen, um Kontaktflächen (6) des Funkmoduls (1) zu kontaktieren.

5. Mobiles Kommunikationsgerät nach Anspruch 4, **dadurch gekennzeichnet, dass** jeder Federkontakt (5) jeweils aus einer zum Funkmodul (1) weisenden Abkröpfung der zungenförmigen Fortsetzung (4) gebildet ist.

6. Mobiles Kommunikationsgerät nach Anspruch 5, **dadurch gekennzeichnet, dass** zumindest die zum Funkmodul (1) weisende Abkröpfung der zungenförmigen Fortsetzung (4) mit einer korrosionsbeständigen Beschichtung beschichtet ist.

7. Mobiles Kommunikationsgerät nach einem der Ansprüche 3 bis 6, **dadurch gekennzeichnet, dass** die Verbindung zwischen Antennenstruktur (3) und Funkmodul-Befestigungsvorrichtung (7) als unlösbare formschlüssige Verbindung, besonders bevorzugt durch eine Nietverbindung (9) ausgebildet ist.

8. Mobiles Kommunikationsgerät nach einem der Ansprüche 3 bis 7, **dadurch gekennzeichnet, dass** die Funkmodul-Befestigungsvorrichtung (7) durch eine Rastverbindung (10) mit dem Schaltungsträger (8) verbindbar ist.

9. Mobiles Kommunikationsgerät nach einem der Ansprüche 3 bis 8, **dadurch gekennzeichnet, dass** die Schlitzantenne (3) als Blech-Biege-Stanzteil hergestellt ist.

10. Mobiles Kommunikationsgerät nach einem der Ansprüche 3 bis 6, **dadurch gekennzeichnet, dass** das Funkmodul (1) quaderförmig ausgebildet ist, dass die Kontaktflächen (6) an einer vom Schaltungsträger (8) abgewandten Quaderfläche des Funkmoduls (1) angeordnet sind und die Schlitzantenne (3) parallel verlaufend zu dieser Quaderfläche angeordnet ist.

## Claims

1. Mobile communications device, comprising:
- a radio module (1),
- an antenna structure (3) connected to the radio module (1),
- a radio module attachment facility (7) to attach the radio module (1) to a plate-shaped circuit carrier (8),
**characterized in that**
- the antenna structure is connected (3) by attachment means (9) to the radio module attachment facility (7), and
- spring contacts (5) are embodied in a terminal area (14) of the antenna structure (3) which, in a state in which the radio module (1) is attached to the circuit carrier (8), establish an electrical connection to contact surfaces (6) which are embodied on the radio module (1).

2. Mobile communications device according to claim 1, **characterized in that** the spring contacts (5) are embodied in one piece with the antenna structure (3).

3. Mobile communications device according to claim 1 or 2, **characterized in that** the antenna structure(3) is embodied as a planar slot antenna, that two tongue-shaped continuations (4) are embodied in the terminal area (14) of the slot antenna and that the spring contacts (5) are formed from these tongue- shaped continuations (4).

4. Mobile communications device according to claim 3, **characterized in that** the radio module attachment facility (7) is embodied as a plastic half shell, that the antenna structure (3) is arranged on an outer side of the plastic half shell facing away from the circuit carrier (8) and the spring contacts (5) engage through a cutout (15) in order to make contact with contact surfaces (6) of the radio module (1).

5. Mobile communications device according to claim 4, **characterized in that** each spring contact (5) is formed from an offset of the tongue-shaped continuation (4) facing towards the radio module (1).

6. Mobile communications device according to claim 5, **characterized in that** at least the offset of the tongue-shaped continuation pointing (4) towards the radio module (1) is coated with a corrosion-resistant coating.

7. Mobile communications device according to one of claims 3 to 6, **characterized in that** the connection between antenna structure (3) and radio module attachment facility (7) is embodied as a non-releasable form-fit connection, especially preferably by a riveted connection (9).

8. Mobile communications device according to one of claims 3 to 7, **characterized in that** the radio module attachment facility (7) is able to be connected to the circuit carrier (8) by a latching connection (10).

9. Mobile communications device according to one of claims 3 to 8, **characterized in that** the slot antenna (3) is manufactured as a metal punch-bend part.

10. Mobile communications device according to one of claims 3 to 6, **characterized in that** the radio module (1) is embodied as a rectangular shape, that the contact surfaces (6) are arranged on a rectangle surface of the radio module (1) facing away from the circuit carrier (8) and the slot antenna (3) is arranged running in parallel to this rectangle surface.

## Revendications

1. Appareil de communication mobile comprenant :
- un module ( 1 ) radio,
- une structure ( 3 ) d'antenne raccordée au module ( 1 ) radio,
- un dispositif ( 7 ) de fixation de module radio, pour fixer le module ( 1 ) radio sur un support ( 8 ) de circuit en forme de plaquette, **caractérisé**
- **en ce que** la structure ( 3 ) d'antenne est reliée par des moyens ( 9 ) de fixation au dispositif ( 7 ) de fixation du module radio, et
- **en ce que**, dans une zone ( 14 ) de connexion de la structure ( 3 ) d'antenne, sont constitués des contacts ( 5 ) à ressort, qui, dans un état dans lequel le module ( 1 ) radio est fixé sur le support ( 8 ) de circuit, ménage une liaison électrique avec des surfaces ( 6 ) de contacts, qui sont constituées sur le module ( 1 ) radio.

2. Appareil de communication mobile suivant la revendication 1, **caractérisé en ce que** les contacts ( 5 ) à ressort sont constitués d'une seule pièce avec la structure ( 3 ) d'entrée.

3. Appareil de communication mobile suivant la revendication 1 ou 2, **caractérisé en ce que** la structure ( 3 ) d'antenne est constituée sous la forme d'une antenne à fente plane, **en ce que**, dans la région ( 14 ) de connexion de l'antenne à fente, deux prolongements ( 4 ) en forme de languette sont formés et **en ce que** les contacts ( 5 ) à ressort sont formés dans ces prolongements ( 4 ) en forme de languette.

4. Appareil de communication mobile suivant la revendication 3, **caractérisé en ce que** le dispositif ( 7 ) de fixation du module radio est constitué en une hémicoquille en matière plastique, **en ce que** la structure ( 3 ) d'antenne est disposée sur un côté extérieur, éloigné du support ( 8 ) du circuit, de l'hémicoquille en matière plastique et des contacts ( 5 ) à ressort passent dans un évidement ( 15 ), pour venir en contact avec des surfaces ( 6 ) de contact des modules ( 1 ) radio.

5. Appareil de communication mobile suivant la revendication 4, **caractérisé en ce que** chaque contact ( 5 ) à ressort est formé respectivement d'un coude du prolongement ( 4 ) en forme de languette.

6. Appareil de communication mobile suivant la revendication 5, **caractérisé en ce qu'**au moins le coude, tourné vers le module ( 1 ) radio, du prolongement ( 4 ) en forme de languette est revêtu d'un revêtement résistant à la corrosion.

7. Appareil de communication mobile suivant l'une des revendications 3 à 6, **caractérisé en ce que** la liaison entre la structure ( 3 ) d'antenne et le dispositif ( 7 ) de fixation du module radio est constituée sous la forme d'une liaison inamovible à complémentarité de forme, d'une manière particulièrement préférée par une liaison ( 9 ) rivetée.

8. Appareil de communication mobile suivant l'une des revendications 3 à 7, **caractérisé en ce que** le dispositif ( 7 ) de fixation du module radio peut être relié au support ( 8 ) du circuit par une liaison ( 10 ) par encliquetage.

9. Appareil de communication mobile suivant l'une des revendications 3 à 8, **caractérisé en ce que** l'antenne ( 3 ) à fente est fabriquée sous la forme d'une pièce en tôle estampée et pliée.

10. Appareil de communication mobile suivant l'une des revendications 3 à 6, **caractérisé en ce que** le module ( 1 ) radio est parallélépipédique, **en ce que** les surfaces ( 6 ) de contact sont disposées sur une surface du parallélépipède du module ( 1 ) radio éloignée du support ( 8 ) de circuit et l'antenne ( 3 ) à fente s'étend parallèlement à cette surface du parallélépipède.
